(19) Europäisches Patentamt
European Patent Office
Office européen des brevets

(11) **EP 2 731 264 A1**

(12) **EUROPEAN PATENT APPLICATION**

(43) Date of publication:
**14.05.2014 Bulletin 2014/20**

(51) Int Cl.:
*H03D 7/10* (2006.01)    *H03D 1/10* (2006.01)

(21) Application number: **12306382.8**

(22) Date of filing: **08.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **Université Montpellier 2 Sciences et Techniques**
  **34090 Montpellier (FR)**
• **Centre National de la Recherche Scientifique**
  **75016 Paris (FR)**
• **Universidad de Salamanca**
  **37008 Salamanca (ES)**

(72) Inventors:
• **Tholme, Lucie**
  **34090 MONTPELLIER (FR)**
• **Varani, Luca**
  **34000 MONTPELLIER (FR)**

• **Nouvel, Philippe**
  **30250 SOUVIGNARGUES (FR)**
• **Song, Aimin**
  **TIMPERLEY, Cheshire WA15 6QS (GB)**
• **Daher, Carlos**
  **34090 Montpellier (FR)**
• **Blin, Stéphane**
  **34000 MONTPELLIER (FR)**
• **Grahn, Jan Vilhelm**
  **427 37 BILLDAL (SE)**
• **Torres, Jérémie**
  **34160 CASTRIES (FR)**
• **Mateos, Javier**
  **37008 SALAMANCA (ES)**
• **Gaquiere, Christophe**
  **59650 VILLENEUVE D'ASCQ (FR)**

(74) Representative: **Pontet Allano & Associes**
  **Parc Les Algorithmes, Bâtiment Platon**
  **CS 70003 Saint Aubin**
  **91192 Gif sur Yvette Cedex (FR)**

(54) **Device and method for direct demodulation of signals with carrier frequencies up to the THz range**

(57)    The present invention concerns a demodulation device for demodulating an electromagnetic signal derived from a modulation of a carrier signal, comprising at least one demodulator and coupling means (21) for coupling said modulated carrier signal to said demodulator(s) so as to generate a demodulated signal representative of the carrier modulation.

The demodulator(s) comprise a self-switching device (SSD) (1) with a conductive substrate and insulating features defining in said conductive substrate an elongated channel.

The present invention concerns also a method for demodulating an electromagnetic signal.

FIG. 4

## Description

### Field of the invention

The invention relates to a device and a method for demodulating electromagnetic waves with carrier frequencies up to the terahertz range.

The field of the invention is, but not limited to, electronic devices for THz applications and ultra-high bandwidth telecommunications.

### Background of the invention

Historically known as the "far-infrared" domain, the terahertz (THz) region is a still under-used region of the electromagnetic spectrum. It extends typically from 100 GHz to 10 THz and corresponds to wavelengths between 3 mm and 30 microns.

The THz frequency domain corresponds in particular to characteristic resonances of many chemicals and biological agents. Thus, THz spectroscopy, which is mainly based on the analysis of vibration modes of complex molecules, is a very promising way of detecting and identifying biological and chemical compounds.

In the telecommunication domain also, the possibility to use signals with carrier frequencies in the THz range opens way to the development of ultra-high bandwidth data transmission systems: the higher is the carrier frequency, the broader is the available bandwidth for transmitting information.

So far, the lack of good quality sources able to deliver enough spectral power is an important limitation to the use of THz waves. However, recent advances in the field of THz illumination sources such as quantum cascade lasers or external mixers, allowing generating THz power of about 10 mW around 1 THz, have open the way to broader THz wave applications.

Detection of modulated THz waves is usually done using heterodyne-type detections.

A heterodyne receiver, as used in heterodyne-type detection, is a receiver which is designed on the principle of frequency mixing, or heterodyning. A received signal (RF) is mixed in a heterodyne mixer with the signal of a local oscillator (LO) to be converted into an intermediate frequency signal (IF), according to a down-conversion process. The frequency of the IF signal is lower than the frequency of the RF signal, so the IF signal is easier to process for demodulation.

One reason why heterodyne detections are generally used is because of the difficulty to demodulate a carrier signal at very high frequency. No components have been reported which allow demodulating directly a signal in the THz range. So the modulation is transposed at the IF frequency where demodulation circuits are available.

For achieving heterodyne detection in the THz frequency range, it is known to use local oscillators such as, for instance:

- Quantum cascade lasers (QCL), but with the double limitation of a relatively limited tunability and of limited operation possibilities at cryogenic temperatures;
- THz waves obtained by the photomixing of the frequencies of two infrared or near-infrared lasers beams in a semiconductor material such as LT-GaAs. This approach has the advantage of allowing high intrinsic tunability and operation at room temperature, but with the disadvantage of a particularly low terahertz power available, of typically less than a microwatt;
- millimeter-wave subharmonically-pumped mixers based on planar GaAs Schottky-diode technology.

For achieving heterodyne detection in the THz frequency range, it is also known to use mixers such as, for instance:

- Schottky diode based mixers. With this kind of mixers, a terahertz local oscillator delivering a few milliwatts of power is required. So Schottky diode based mixers are usually combined with low frequency QCLs. This approach can be extended between 2 and 3 THz, but as the performances of the mixers tend to deteriorate at higher frequencies, the local oscillator power must be increased accordingly and finally the overall sensitivity of the detection system decreases;
- Hot electron bolometers (HEB) mixers. Due to the low level of power usually supplied by THz sources used as local oscillators, high-performance mixers such as the HEBs, which are derived from the space industry, are often required. Tunable terahertz sources such as photomixers may be used. But again, the required local oscillator power tends to increase as the frequency increases. In the frequency range of 2 to 3 THz, the required power becomes difficult to obtain by photomixing and it is better to use QCLs.

All these detection schemes currently require the implementation of cryogenic systems, as they use components which must be operated at very low temperatures.

So, the known heterodyne detection schemes in the THz frequency range still have important limitations:

- available THz mixers such as bolometers or Schottky diodes have a low sensitivity and require the use of local oscillators with a high power to achieve heterodyne detection schemes with high sensitivity. So quantum cascade lasers are usually needed;
- the tunability of these heterodyne detection schemes is in general limited, and so is the possibility of achieving broadband detection;
- as most of these systems operate at low temperatures, they turn out to be quite bulky and very expensive.

In addition, coupling THz radiations waves in components such as Schottky diodes is not easy. Schottky diodes are made of successions of layers, and the THz waves must be coupled on the side of the component. So the practical implementation may be complex, as it requires a tight focusing of the THz waves, with the risk of a poor coupling efficiency.

Beside of being complex and expensive, heterodyne detection introduce also a fundamental limitation on the bandwidth available for data transmission. Even if the carrier frequency of the detected signal is in the THz range, the bandwidth which is actually available for data transmission (or the maximum modulation bandwidth) is limited by the frequency of the IF signal. So, heterodyne detection is not well-fitted for ultra-high bandwidth detection.

It is an object of the invention to provide a demodulation device for demodulating signals with carrier frequency up to the THz frequency range, which overcomes the limitations of the prior art.

It is a further object of the invention to provide a demodulation device which allows ultra-high bandwidth operation.

It is still a further object of the invention to provide a demodulation device, which allows an easy implementation and operation at room temperature.

## Summary of the invention

Such objects are accomplished with a demodulation device for demodulating an electromagnetic signal derived from a modulation of a carrier signal, comprising at least one demodulator and coupling means for coupling said modulated carrier signal to said demodulator(s) so as to generate a demodulated signal representative of said carrier modulation, **characterized in that** said demodulator(s) comprise(s) a self-switching device (SSD) with a conductive substrate and insulating features defining in said conductive substrate an elongated channel, said elongated channel providing a charge carrier flow path in said conductive substrate between first and second areas, and being dimensioned and arranged such that said charge carrier flow path is limited by depletion regions the size of which is dependent on a voltage difference between said first and second areas.

The demodulation device of the invention may comprise first coupling means for coupling to the self-switching device a modulated carrier signal in the form of electromagnetic waves, and second coupling means for transmitting a demodulated signal.

The second coupling means may comprise wired connections with the first and second areas of the self switching device(s).

The first coupling means may comprise at least one planar antenna with a pair of conductive patches connected respectively to the first and second areas of the self switching device(s).

The demodulation device of the invention may comprise biconical or bowtie antenna(s), with the self switching device(s) inserted between the patches of said antenna(s).

The antenna(s) and the self-switching device(s) may be comprised on the same surface. They may be for instance part of a same surface of a component.

According to some modes of realization, the demodulation device of the invention may comprise:

- any kind of antenna, adapted to the signals to be coupled;
- antennas located on the side of the component opposing the surface with the self-switching device(s);

According to some modes of realization, the demodulation device of the invention may comprise:

- several self-switching devices connected in parallel to the patches of the antenna(s);
- a plurality of antennas oriented according to a similar direction;
- a plurality of antennas connected in series and/or in parallel by conductive links between their patches, so as to form an array of antennas and demodulators.

According to some modes of realization, the demodulation device of the invention may be able to process electromagnetic signals with frequencies higher than 0.2 THz.

According to another aspect of the invention, it is proposed a method for demodulating an electromagnetic signal derived from a modulation of a carrier signal, comprising steps of:

- coupling a modulated carrier signal to a demodulation device of the invention,
- collecting a demodulated signal representative of the carrier modulation.

According to some modes of realization, the method of the invention may further comprise steps of:

- irradiating the demodulation device, implementing at least one antenna, with a carrier signal in the form of an electromagnetic wave.

It may further comprise steps of:

- irradiating the demodulation device with a modulated carrier signal incident on the surface of the device holding the antenna(s), or opposite to said surface;
- irradiating the demodulation device with a linearly polarized carrier signal having an axis of polarization substantially parallel to the orientation of at least some of the antenna(s).
- irradiating several antennas of an array of antenna and demodulators with a modulated carrier signal, and collecting a demodulated signal on said array of antennas and demodulators using wired connections.

According to still another aspect of the invention, it is proposed a system for demodulating an electromagnetic signal derived from a modulation of a carrier signal, comprising:

- a demodulator device of the invention with an array of antennas and demodulators,
- means for directing a carrier signal in the form of an electromagnetic wave on one side of the antenna(s),
- wired connection means for collecting a demodulated signal on said array of antennas and demodulators.

**Description of the drawings**

The methods according to embodiments of the present invention may be better understood with reference to the drawings, which are given for illustrative purposes only and are not meant to be limiting. Other aspects, goals and advantages of the invention shall be apparent from the descriptions given hereunder.

- Fig. 1a illustrates a front-view of a self-switching device (SSD), while Fig. 1b, Fig. 1c and Fig. 1d illustrates the modes of operation of the device,
- Fig. 2 illustrates a current-voltage characteristic of a SSD,
- Fig. 3 illustrates a front-view of a demodulation device of the invention,
- Fig. 4 illustrates a detailed view of an antenna of the demodulation device of the invention,
- Fig. 5 illustrates a side view of a demodulation device of the invention showing the coupling of electromagnetic wave signal,
- Fig. 6 illustrates the direct demodulation process of a signal by a device of the invention.

**Detailed description of the invention**

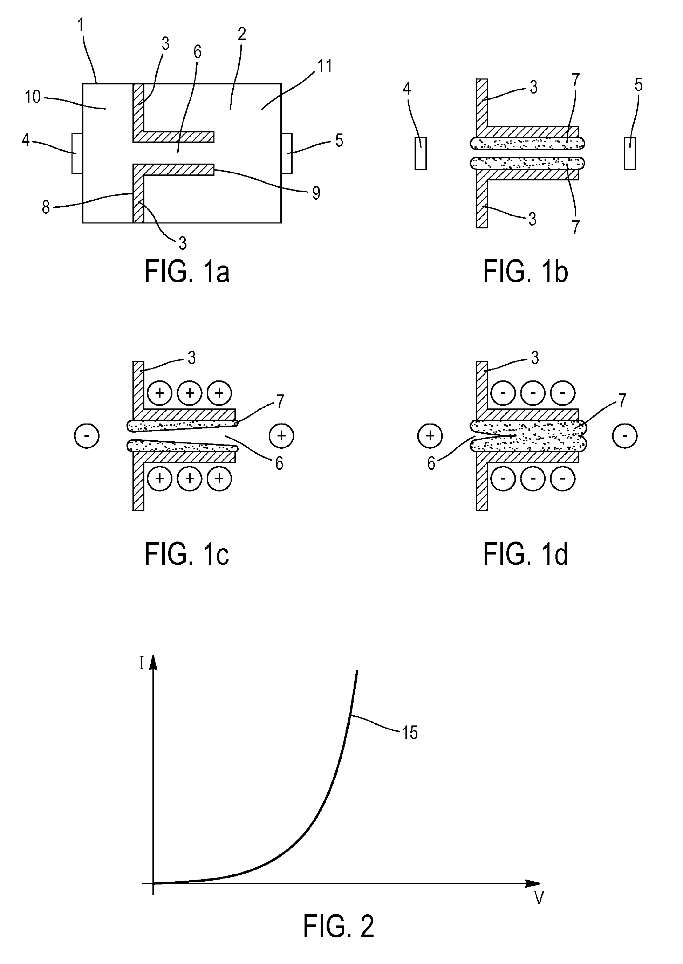

With reference to Fig. 1a, a demodulation device of the invention comprises one or several components usually referred to as "Self-Switching Device", or SSD 1. These SSDs 1 are used as demodulators for demodulating the signals, as explained later.

Examples of SSDs 1 and modes of realization of such components applicable in the context of the invention are described in the document WO 02/086973.

A SSD 1 comprises a conductive layer 2. This conductive layer 2 is made for instance in an INGaAs/InP substrate containing a conductive layer with mobile electrons, located about 50 nm below the surface.

Other material arrangements may be used for the manufacturing of the SSDs 1:

- high mobility materials such as InAs or InSb may be used in order to reach much higher frequencies;
- even if heterojunctions provide the best performances, a material structure comprising a doped layer on top of an isolating substrate, such as SOI (Silicon On Insulator), may be used for manufacturing the SSDs 1. In that case, the results in terms of cutoff frequencies may be not the best, but the use of a silicon-based technology may be advantageous for the integration.

Insulating trenches 3 are made in that conductive layer 2, using a wet chemical etching technique, or a radiative ion etching (RIE) technique. These insulating trenches 3 are for instance about 100 nm deep, so as to be deeper than the conductive layer 2, and to form insulating lines 3.

The insulating lines 3 comprise first insulating lines 8 which separate the conductive layer 2 into a first area 10 and a second area 11, except for a channel 6.

The insulating lines 3 comprise also second insulating lines 9 which extend from the first insulating lines 8 into the second area 11. These second insulating lines 9 define thus an elongated channel 6 in the conductive layer 2, which provides an electron flow path for mobile electrons to travel between the first area 10 and the second areas 11. This elongated channel 6 has a typically a length in the order of 1 to 2 micrometers and a width in the order of 50 nm to 100 nm.

The first area 10 and the second area 11 of the conductive layer 2 are connected to electrical terminals 4, 5, respectively.

With reference to Fig. 1b, when no voltage is applied between terminals 4, 5, depletion regions 7 appear in the elongated channel 6 along the insulating line 9, so that only a narrow area of the flow path is available for electron conduction. These depletion regions 7 are due to surface states and Fermi levels at the etched surface.

With reference to Fig. 1c, when a positive voltage is applied to terminal 5 and a negative voltage is applied to terminal 4 (or at least when a higher voltage is applied to terminal 5 than to terminal 4), a positive voltage exists on the outer side of insulating lines 9, which contributes to decrease the size of the depletion regions 7 by electrostatically lowering the potential in the channel 6. So the electron conduction and therefore the current flowing in the channel 6 are larger.

With reference to Fig. 1d, when now a negative voltage is applied to terminal 5 and a positive voltage is applied to terminal 4 (or at least when a lower voltage is applied to terminal 5 than to terminal 4), a negative voltage exists on the outer side of insulating lines 9, which contributes to increase the size of the depletion regions 7 by electrostatically increasing the potential in the channel 6. This creates a narrower channel or even a pitched-off channel. Thus only little or even no current may flow in the channel 6.

Fig. 2 shows a typical current-voltage characteristic 15 of SSD 1. Current I is plotted in function of voltage V.

It can be seen that the behavior of such component is quite similar to that of a semiconductor diode:

-    when a negative voltage is applied on the terminals 4, 5, no current flows through the SSD 1;
-    when a positive voltage, higher that a threshold, is applied on these terminals, a current flows through the SSD 1;
-    the current varies in a non-linear way for some ranges of positive voltages.

The current-voltage characteristics 15 may further be modified by modifying structural parameters of the component such as dimensions and shape of the channel 6, but also by applying a DC bias voltage on the terminals 4, 5.

For instance:

-    when the width of the channel 6 is increased, the shape of the current-voltage curve becomes more similar to that of a non symmetric resistor (with a saturation for high bias);
-    reducing the length of the channel 6 allows increasing the cutoff frequencies;
-    a geometrical asymmetry, such as for instance a V-shaped geometry in which the channel 6 has a width that varies from one extremity to the other like a "V", increases the non-linearity of the current-voltage curve, and in particular of the quadratic terms.

So, a SSD 1 behaves, at least in some extends, like a semiconductor diode even if it works on a completely different principle.

The document WO 02/086973 reports possible uses of SSDs as rectifiers for detecting average power of high-frequency signals.

In this kind of applications, a high-frequency voltage is applied on terminals 4, 5 of a SSD and the average current flowing through the component is measured at low frequencies. As the current is blocked on one direction, its average has a non-zero value which is representative of the average voltage of the high-frequency signal.

The use of diodes for demodulating amplitude-modulated signals is of course known. When a high-frequency carrier signal with a carrier at frequency $f_c$ modulated in amplitude with a modulation signal at frequency $f_m$ for instance is applied on a diode 1, the modulation signal at frequency $f_m$ may be obtained from the current flowing through the diode. The modulation signal lays actually in the variations, in amplitude, of the positive parts of the carrier signal which are not rejected by the diode.

More precisely, when applying a modulated, high frequency carrier voltage on the diode such as:

$$V(t) \sim (1 + m \cos(2\pi f_m t)) \cos(2\pi f_c t) \hspace{4cm} (\text{Eq. 1})$$

One gets a current which directly contains the modulation information, which may be accessed after proper filtering:

$$I(t) \sim \cos(2\pi f_m t). \hspace{4cm} (\text{Eq. 2})$$

Of course, the same applies for all modulation frequencies $f_m$ in case of broadband modulation signal.

In practice, direct demodulation is rarely used for high-frequency carrier signals, because notably of the requirements in terms of bandwidth of the components.

Usually, the modulated carrier signal is transposed in a first step at a lower intermediate frequency by heterodyne mixing with an oscillator. And then the demodulation is done at that lower frequency.

It is an advantage of the invention to have recognized that SSDs 1 may have a current-voltage characteristic 15 usable for demodulation applications within a bandwidth extending up to the THz range. In other words, the voltage-current characteristic 15 of the SSD 1 as shown in Fig. 2 may be preserved at all useful frequencies within the range.

Simulation results have shown that a stable current-voltage characteristic 15 may be obtained in a frequency range extending from DC to 450 GHz, or even to 2 THz with some configurations of SSDs 1, using for instance high mobility materials and channels 6 with reduced length as previously explained. In other words the current bandwidth may be extended up to 2 THz at least.

This means that SSD can be used for direct demodulation of signals with carrier frequency $f_c$ up to 2 THz and modulation frequencies $f_m$ of several hundred of GHz. So, huge bandwidth can be achieved for data transmission.

In addition, these performances may be obtained at room temperature, without cooling.

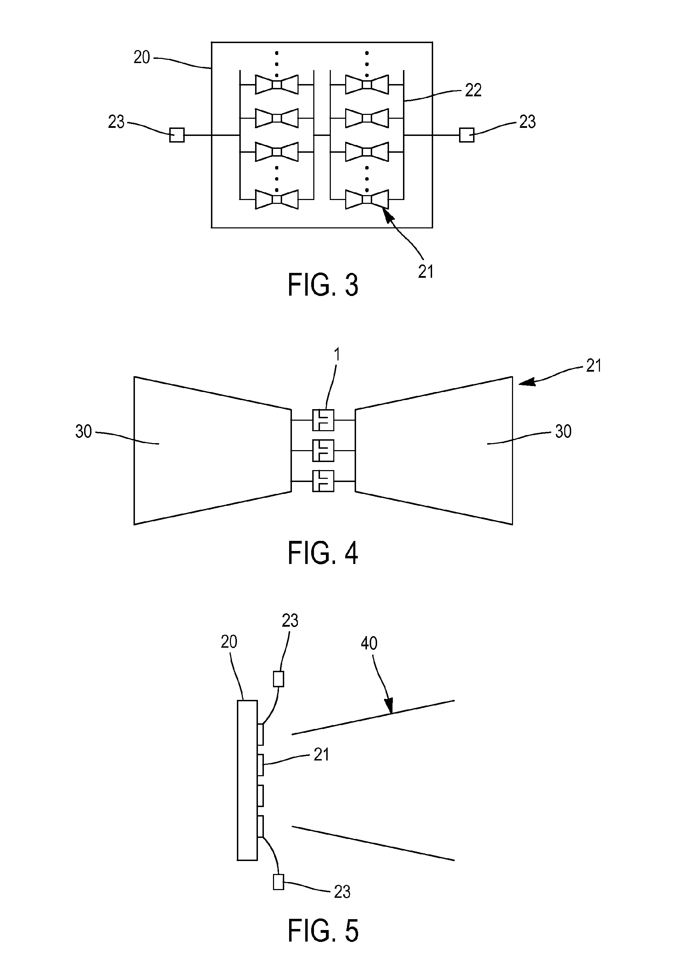

With reference to Fig. 3, Fig. 4 and Fig. 5, we will now describe a demodulation device 20 using SSD demodulators 1 for demodulating carrier signals 40 in the THz range and obtaining modulation signals.

The demodulation device 20 of the invention comprises several SSD demodulators 1. These demodulators 1 are connected through their terminals 4, 5 to pairs of patches 30 with a conical shape forming bow-ties antennas 21 (or other types of antennas). Several SSDs 1 are connected in parallel to a pair of patches 30 of an antenna 21. These SSDs 1 may be done as distinct components, or they may share the same conductive surface 2 just comprising several channels 6 in parallel.

The antennas 21 are connected in parallel by conductive links 22, so as to form columns of antennas 21. Several columns of antennas 21 are in turn connected in series so as to form an array of antennas 21 and demodulators 1.

All the antennas 21 are oriented along the same direction.

The antennas 21 and the SSD demodulators 1 are all done on a same surface of a component 20 using classical techniques from the semiconductor industry. Antenna patches 30 may for instance be made of pieces or metal vacuum-deposited on the surface holding the already-done SSD. Components bounding may be done by using gold micro-wires. Components bounding may also be done by direct integration of components and/or connection tracks during the fabrication.

So the demodulation device 20 of the invention is particularly easy to realize.

The planar structure allows also an easy and efficient coupling of high-frequency signals. The carrier signal is brought in the form of a beam 40 or electromagnetic wave which is focused onto the surface of the demodulation device 20. The beam 40 is focused on the surface holding the antennas 21 (or possibly on the surface opposite), and is coupled with the antennas 21.

The beam 40 is linearly polarized, with its axis of polarization aligned with the axis of the antennas 21.

The electric field intercepted by each of the antennas 21 induces a voltage difference on the terminals 4, 5 of the SSD demodulators 1 which are connected to the patches 30. As explained before, a resulting current with frequency content at modulation frequencies $f_m$ appears on the SSD terminals 4, 5.

As the SSDs 1 of the device 20 are connected in series and in parallel, the resulting currents combine and may be collected at the terminals 23 of the demodulation device, and eventually converted in voltage.

A large part of the surface of the demodulation device is occupied by the antennas 21, so the structure allows very efficient coupling of the power of the high-frequency carrier signal 40. The modulation signals generated at modulation frequencies by all SSDs 1 are also combined in power to be efficiently collected at the component's terminals 23.

It is important to notice that this simple and efficient architecture is made possible by the fact that SSDs 1 have a planar structure requiring only one conductive layer, and that they allow power coupling by the face. This is an important advantage of the device of the invention compared for instance to demodulators based on schottky diodes whose manufacturing requires several layers and in which the coupling of high-frequency power must be done by the side of these layers.

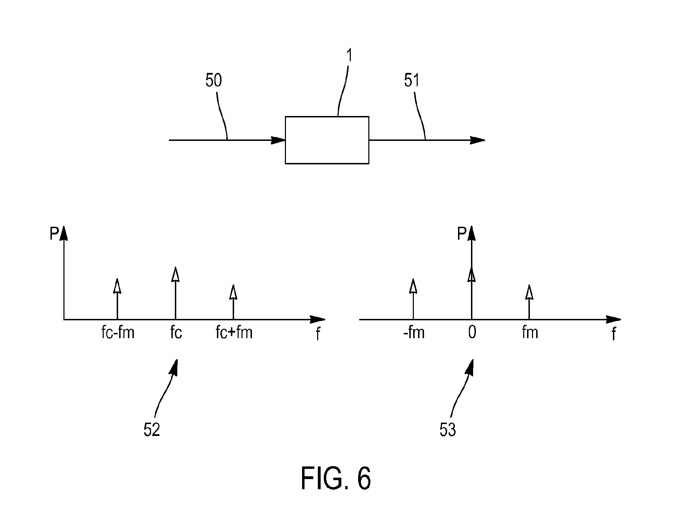

Fig. 6 illustrates the direct demodulation of a modulated signal 50 by a SSD demodulator 1.

As a matter of example, a modulated signal 50 with a carrier frequency $f_c$ in the THz range modulated in amplitude by a harmonic signal at modulation frequency $f_m$ is coupled to the SSD demodulator 1. This signal 50 may be for instance such as described by Eq. 1. In that case, its amplitude spectrum 52 comprises a component at carrier frequency $f_c$ surrounded by components at frequencies $f_c + f_m$ et $f_c - f_m$, respectively.

As previously explained, a modulation current 51 appears on the terminals of the SSD demodulator 1, which contains the modulation information. In the example of Fig. 6, this modulation current may be such as described by Eq. 2. Its amplitude spectrum 53 comprises components at modulation frequency $\pm f_m$ which correspond directly to the modulation signal to be extracted, in baseband. So the detection of the modulation current 51, possibly followed by a proper filtering, allows detecting directly the modulation signal carried by the modulated signal 50, in baseband.

Of course, the same detection scheme may be applied to any kind of modulation which may be processed in baseband.

The modulated signal 50 may be of course a modulated wave 40 incident on a demodulation device 20 of the invention, comprising several SSDs demodulator 1. In that case the SSD demodulators 1 cooperate to generate a modulation current 51, or more generally speaking a modulation signal 51 with the modulation information. And this modulation signal 51 may be collected at the terminals 23 of the demodulation device 20.

While this invention has been described in conjunction with a number of embodiments, it is evident that many alternatives, modifications and variations would be or are apparent to those of ordinary skill in the applicable arts. Accordingly, it is intended to embrace all such alternatives, modifications, equivalents and variations that are within the spirit and scope of this invention.

## Claims

1. A demodulation device (20) for demodulating an electromagnetic signal derived from a modulation of a carrier signal, comprising at least one demodulator and coupling means (21) for coupling said modulated carrier signal to said demodulator(s) so as to generate a demodulated signal representative of the carrier modulation,
   **characterized in that** said demodulator(s) comprise(s) a self-switching device (SSD) (1) with a conductive substrate (2) and insulating features (3, 8, 9) defining in said conductive substrate an elongated channel (6), said elongated channel (6) providing a charge carrier flow path in said conductive substrate (2) between first and second areas (10, 11), and being dimensioned and arranged such that said charge carrier flow path is limited by depletion regions the size of which is dependent on a voltage difference between said first and second areas (10, 11).

2. The demodulation device of claim 1, which comprises first coupling means (21) for coupling to the self-switching device (1) a modulated carrier signal in the form of electromagnetic waves, and second coupling means (4, 5, 23) for transmitting a demodulated signal.

3. The demodulation device of claim 2, wherein the second coupling means comprise wired connections (4, 5) with the first and second areas (10, 11) of the self switching device(s) (1).

4. The demodulation device of claim 2 or 3, wherein the first coupling means comprise at least one planar antenna (21) with a pair of conductive patches (30) connected respectively to the first and second areas (10, 11) of the self switching device(s) (1).

5. The demodulation device of claim 4, which comprises biconical or bowtie antenna(s) (21), with the self switching device(s) (1) inserted between the patches (30) of said antenna(s) (21).

6. The demodulation device of any of claims 3 to 5, wherein the antenna(s) (21) and the self-switching device(s) (1) are comprised on the same surface.

7. The demodulation device of any of claims 3 to 6, which comprises several self-switching devices (1) connected in parallel to the patches (30) of the antenna(s) (21).

8. The demodulation device of any of claims 3 to 7, which comprises a plurality of antennas (21) oriented according to a similar direction.

9. The demodulation device of any of claims 3 to 8, which comprises a plurality of antennas (21) connected in series and/or in parallel by conductive links (22) between their patches (30), so as to form an array of antennas and demodulators.

10. The demodulation device of any of the preceding claims, which is able to process electromagnetic signals (40) with frequencies higher than 0.2 THz.

11. A method for demodulating an electromagnetic signal derived from a modulation of a carrier signal, **characterized in that** it comprises steps of:

   - coupling a modulated carrier signal to a demodulation device (20) according to any of claims 1 to 10,
   - collecting a demodulated signal representative of the carrier modulation.

12. The method of claim 11, which further comprises a step of irradiating the demodulation device, implementing at least one antenna (21), with a carrier signal in the form of an electromagnetic wave (40).

13. The method of claim 12, which comprises a step of irradiating the demodulation device (20) with a modulated carrier signal incident on the surface of the device holding the antenna(s) (21), or opposite to said surface.

14. The method of claim 12 or 13, which further comprises steps of irradiating the demodulation device (20) with a linearly polarized carrier signal 40) having an axis of polarization substantially parallel to the orientation of at least some of the antenna(s) (21).

15. The method of any of claims 12 to 14, which further comprises steps of irradiating several antennas (21) of an array of antenna and demodulators with a modulated carrier signal (40), and collecting a demodulated signal on said array of antennas and demodulators using wired connections (23).

16. A system for demodulating an electromagnetic signal derived from a modulation of a carrier signal, comprising:

   - a demodulator device (20) according to claim 9 or 10 with an array of antennas and demodulators,
   - means for directing a carrier signal in the form of an electromagnetic wave (40) on one side of the antenna(s) (21),
   - wired connection means (23) for collecting a demodulated signal on said array of antennas and demodulators.

FIG. 1a

FIG. 1b

FIG. 1c

FIG. 1d

FIG. 2

FIG. 3

FIG. 4

FIG. 5

FIG. 6

| | Europäisches Patentamt<br>European Patent Office<br>Office européen des brevets | **EUROPEAN SEARCH REPORT** | Application Number<br>EP 12 30 6382 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | C. BALOCCO ET AL: "Microwave Detection at 110 GHz by Nanowires with Broken Symmetry", NANO LETTERS, vol. 5, no. 7, 1 July 2005 (2005-07-01), pages 1423-1427, XP055056485, ISSN: 1530-6984, DOI: 10.1021/nl050779g<br>* page 1424, column 1, paragraph 1 - column 2, paragraph 1; figure 1 *<br>* page 1425, column 1, paragraph 4 * | 1-3, 8-11, 14-16 | INV.<br>H03D7/10<br>H03D1/10 |
| Y | US 6 265 940 B1 (ADACHI KEIGO [JP]) 24 July 2001 (2001-07-24)<br><br>* column 1, line 37 - line 45; figure 4 * | 1,2, 8-11, 14-16 | |
| Y | US 7 224 026 B2 (SONG AIMIN [GB] ET AL) 29 May 2007 (2007-05-29)<br>* claims 1,2; figures 1,7 * | 1-16 | |
| Y | US 4 461 039 A (HERSMAN MICHAEL S [US]) 17 July 1984 (1984-07-17)<br>* figure 1 * | 1,2,4,5, 7-16 | TECHNICAL FIELDS SEARCHED (IPC)<br><br>H03D |
| Y | EP 0 193 849 A2 (GEN ELECTRIC [US]) 10 September 1986 (1986-09-10)<br>* figure 2 * | 1,2,4-16 | |
| Y | US 2 894 132 A (ROBERT SKYTEN) 7 July 1959 (1959-07-07)<br><br>* figure 1 * | 1-3, 8-11, 14-16 | |

The present search report has been drawn up for all claims

| Place of search | Date of completion of the search | Examiner |
|---|---|---|
| Munich | 15 March 2013 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 .................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 12 30 6382

This annex lists the patent family members relating to the patent documents cited in the above-mentioned European search report.
The members are as contained in the European Patent Office EDP file on
The European Patent Office is in no way liable for these particulars which are merely given for the purpose of information.

15-03-2013

| Patent document cited in search report | | | Publication date | Patent family member(s) | | | Publication date |
|---|---|---|---|---|---|---|---|
| US 6265940 | B1 | | 24-07-2001 | JP | 2001203536 | A | 27-07-2001 |
| | | | | US | 6265940 | B1 | 24-07-2001 |
| US 7224026 | B2 | | 29-05-2007 | AT | 363733 | T | 15-06-2007 |
| | | | | CA | 2444681 | A1 | 31-10-2002 |
| | | | | CN | 1669144 | A | 14-09-2005 |
| | | | | DE | 60220394 | T2 | 31-01-2008 |
| | | | | EP | 1380053 | A2 | 14-01-2004 |
| | | | | ES | 2287309 | T3 | 16-12-2007 |
| | | | | JP | 4902094 | B2 | 21-03-2012 |
| | | | | JP | 2004534388 | A | 11-11-2004 |
| | | | | US | 2004149679 | A1 | 05-08-2004 |
| | | | | WO | 02086973 | A2 | 31-10-2002 |
| US 4461039 | A | | 17-07-1984 | NONE | | | |
| EP 0193849 | A2 | | 10-09-1986 | EP | 0193849 | A2 | 10-09-1986 |
| | | | | US | 4607394 | A | 19-08-1986 |
| US 2894132 | A | | 07-07-1959 | DE | 1041111 | B | 16-10-1958 |
| | | | | US | 2894132 | A | 07-07-1959 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 02086973 A